(19) Europäisches Patentamt / European Patent Office / Office européen des brevets

(11) **EP 4 390 464 A1**

(12) # EUROPEAN PATENT APPLICATION

(43) Date of publication:
**26.06.2024 Bulletin 2024/26**

(21) Application number: **22216582.1**

(22) Date of filing: **23.12.2022**

(51) International Patent Classification (IPC):
**G01T 1/24** $^{(2006.01)}$    **H01L 31/115** $^{(2006.01)}$
**H01L 31/028** $^{(2006.01)}$

(52) Cooperative Patent Classification (CPC):
**H01J 37/04; G01T 1/242; G01T 1/244; H01J 37/12;**
**H01L 31/028; H01L 31/115;** H01J 2237/0453;
H01J 2237/1205; H01J 2237/1534

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **NIHTIANOV, Stoyan**
**5500 AH Veldhoven (NL)**

(74) Representative: **ASML Netherlands B.V.**
**Corporate Intellectual Property**
**P.O. Box 324**
**5500 AH Veldhoven (NL)**

(54) **DETECTOR FOR DETECTING RADIATION**

(57)    A detector for detecting radiation is disclosed. In one arrangement, the detector has a sensing element that comprises a semiconducting sensor substrate (402) and is configured such that impingement of target radiation generates charge carriers in the sensor substrate. Readout circuitry provides an output responsive to charge carriers generated in the sensor substrate. The sensor substrate comprises a low bandgap layer (408) and a high bandgap portion (409).

## Fig. 10

**Description**

FIELD

The present disclosure relates to detectors for detecting radiation and associated apparatus and methods, and is particularly applicable to the context of charged particle-based microscopy.

BACKGROUND

Detectors may be used for sensing physically observable phenomena. For example, charged particle beam tools, such as electron microscopes, may comprise detectors that receive charged particles projected from a sample and that output a detection signal. Detection signals can be used to reconstruct images of sample structures under inspection and may be used, for example, to reveal defects in the sample. Detection of defects in a sample is increasingly important in the manufacturing of semiconductor devices, which may include large numbers of densely packed, miniaturized integrated circuit (IC) components. Dedicated inspection tools may be provided for this purpose.

In some applications in the field of inspection, for example microscopy using a scanning electron microscope (SEM), an electron beam may be scanned across a sample to derive information from backscattered or secondary electrons generated from the sample. In a related art, electron detection systems in SEM tools may include a detector configured to detect electrons coming from the sample. Existing detectors in SEM tools may detect only the intensity of the beam. In some detection methods, a large area semiconductor detector or a group of small area semiconductor detectors having an area equal to, smaller, or larger than the area of the beam spot may be used. Current induced by the incoming electron beam may be generated within the detector and then amplified by an amplifier following the detector. Performance of the detection may be limited due to the amplifier, resulting for instance in a poor signal-to-noise ratio (SNR), particularly when beam current reduces to, for example, pico-ampere ranges.

With continuing miniaturization of semiconductor devices, inspection systems may use lower and lower electron beam currents. As beam current decreases, maintaining acceptable signal to noise (SNR) becomes even more difficult. For example, when probe current decreases to 200 pA or below, SNR may drop off dramatically. Poor SNR may require taking measures such as image averaging or extending the integration time of signal corresponding to each pixel in the image of the sample, which may increase the electron dose on the sample surface, resulting in surface charging artifacts or other detrimental effects. Such measures may also lower the overall throughput of the inspection system.

Detectors providing active internal gain due to avalanche may be attractive because they can provide stronger output signals. Stronger output signals are desirable because they allow simpler and/or lower power readout electronics (e.g., amplifiers) to be used. Known detectors of this type include single photon avalanche detectors (SPAD), silicon photomultipliers (SiPM), and avalanche photodetectors (APD). Some implementations of such detectors have disadvantages. For example, the detectors may need time to recover after individual avalanches. During the recovery time the detectors will not be able to detect incoming radiation. The detectors may also have a relatively low fill factor due to the need to avoid crosstalk between neighboring detector pixels (e.g., to avoid an avalanche in one pixel triggering an avalanche in a neighboring pixel). The fill factor in such detectors can be as low as 40-50%.

SUMMARY

It is an object of the present disclosure to provide an improved detector for detecting radiation.

According to an aspect of the invention, there is provided a detector for detecting radiation, comprising: a sensing element comprising a semiconducting sensor substrate, the sensing element being configured such that impingement of target radiation into the sensor substrate generates charge carriers in the sensor substrate; and readout circuitry configured to provide an output responsive to charge carriers generated in the sensor substrate, wherein: the sensor substrate comprises a low bandgap portion consisting of a low bandgap material and a high bandgap portion consisting of a high bandgap material, the low bandgap material having a bandgap lower than a bandgap of the high bandgap material.

Providing a low bandgap portion increases passive internal gain. Arranging for the sensor substrate to comprise both low and high bandgap portions allows the increased passive internal gain to be achieved without excessively increasing dark current.

In an embodiment, the readout circuitry is configured to operate the sensing element as a reverse biased diode having a depletion region in the sensor substrate, the charge carriers being generated in the depletion region in the sensor substrate. In an embodiment, the high bandgap portion forms a majority of the depletion region. Arranging for the high bandgap portion to form a majority of the depletion region allows the depletion region to be made relatively large without excessively increasing dark current. Making the depletion region relatively large may beneficially reduce junction capacitance and improve noise performance.

In an embodiment, the low bandgap portion comprises a low bandgap layer. Providing the low bandgap portion in the form of a layer may facilitate positioning of the low bandgap layer to interact effectively with impinging target radiation.

In an embodiment, the low bandgap layer is substantially planar and perpendicular to a width of the depletion region in a direction of the reverse bias and/or to a surface of the sensing element configured to receive the target radiation. Orienting the low bandgap layer in this manner may promote effective interaction with impinging target radiation.

In an embodiment, at least a portion of the low bandgap layer is located at, or is nearer than the depletion region to, a surface of the sensing element configured to receive the target radiation. Positioning the low bandgap layer at or near the surface may provide good performance for a range of target radiation energy distributions because at least a portion of the target radiation will be absorbed relatively near to the surface.

In an embodiment, the low bandgap layer is provided at a depth within the sensor substrate such that a portion of the depletion region is between the low bandgap layer and a surface of the sensing element configured to receive the target radiation. Positioning the low bandgap layer at a depth may encourage electrons to be generated further away from the surface, thereby reducing losses of charge carriers from the surface or due to recombination events associated with defects at or near the surface. Additionally or alternatively, positioning the low bandgap layer at a depth may allow the low bandgap layer to correspond to a wider region of the expected bulbous form of a volume of interaction between the impinging radiation and the sensor substrate. The interaction volume may for example have a maximum cross-sectional area (in a direction parallel with the surface) at a finite depth within the sensor substrate.

In an embodiment, the thickness and/or position of the low bandgap layer is/are selected according to an energy distribution of the target radiation, optionally an average energy of the target radiation. For example, the thickness and/or position may be selected to account for the cross-sectional area of the interaction volume being largest at a finite depth.

In an embodiment, the low bandgap layer has a composition that varies as a function of position in a thickness direction of the low bandgap layer. In an embodiment, the variation in composition is such that the composition converges towards a composition of material outside of the low bandgap layer and in contact with the low bandgap layer on one or both sides of the low bandgap layer. Arranging for such convergence in composition may reduce mismatches in the lattice at one or both of the interfaces between the low bandgap layer and surrounding material, thereby reducing the amount of lattice defects such as dislocations, thereby reducing recombination events and improving internal gain.

In an embodiment, the low bandgap portion comprises a plurality of the low bandgap layers. In an embodiment, each of the low bandgap layers has a thickness that is small enough to lower the bandgap of the material of the low bandgap layer. Lowering the bandgap can increase passive internal gain. Providing multiple low bandgap layers provides a larger total thickness of low bandgap material. Providing the total thickness as multiple thin layers rather than a single thicker layer achieves a lower average bandgap in the low bandgap material due to the suppressive effect on bandgap from the thinness of the individual layers, thereby improving overall passive internal gain.

In an embodiment, at least a subset of the low bandgap layers are configured to generate charge carriers predominantly from target radiation having different respective energy distributions or different respective average energies. For example, different layers of the subset may be positioned at significantly different depths within the sensor substrate. Spacing multiple layers apart in this manner increases flexibility of operation and efficiency by allowing the detector to have a high passive internal gain for a range of different target radiations.

In an embodiment, the low bandgap material comprises a material having the same crystal structure as the high bandgap material and/or with a lattice constant within 10% of a lattice constant of the high bandgap material. Reducing a mismatch between the lattice structure of the low bandgap material and high bandgap material may reduce defects such as dislocations that can act as recombination centers and reduce passive internal gain.

According to an aspect of the invention, there is provided a method of manufacturing a sensing element for a detector for detecting radiation, wherein: the sensing element comprises a semiconducting sensor substrate configured to generate charge carriers on impingement of target radiation into the sensor substrate, the sensor substrate comprises a low bandgap layer forming a portion of the sensor substrate and having a bandgap lower than the bandgap of a high bandgap material forming another portion of the sensor substrate, and the method comprises: forming a plurality of candidate sensor substrates with different configurations of the low bandgap layer, the different configurations including either or both of different thicknesses and different positions of the low bandgap layer in the sensor substrate; measuring internal gains of the candidate sensor substrates when subjected to target radiation; selecting as a final configuration of the low bandgap layer the configuration corresponding to the highest measured internal gain; and manufacturing the sensor element by forming the sensor substrate with the low bandgap layer according to the selected final configuration of the low bandgap layer.

It is to be understood that both the foregoing general description and the following detailed description are exemplary and explanatory only and are not restrictive of the disclosed embodiments, as may be claimed.

BRIEF DESCRIPTION OF THE DRAWINGS

The above and other aspects of the present disclosure will become more apparent from the description of exemplary embodiments, taken in conjunction with the accompanying drawings.

Fig. 1 is a schematic diagram illustrating an exemplary electron beam inspection (EBI) system, consistent with embodiments of the present disclosure.

Fig. 2A and Fig. 2B are schematic diagrams illustrating exemplary electron beam tools, consistent with embodiments of the present disclosure that may be a part of the exemplary electron beam inspection system of Fig. 1.s

Fig. 3A is a representation of an exemplary structure of a detector, consistent with embodiments of the present disclosure.

Fig. 3B and Fig. 3C are diagrams illustrating cross-sectional views of detectors, consistent with embodiments of the present disclosure.

Fig. 3D and Fig. 3E are diagrams illustrating cross-sectional views of individual detector elements, consistent with embodiments of the present disclosure.

Fig. 4A is a view of a portion of Fig. 2B showing secondary electrons being projected toward a detector from a sample.

Fig. 4B illustrates an example of secondary electron landing point distribution on a detector surface, consistent with embodiments of the present disclosure.

Fig. 5 depicts a schematic representation of a portion of an element in a MEMS-based miniature SEM array according to an embodiment of the disclosure.

Fig. 6 depicts a schematic representation of a detector array according to an embodiment of the disclosure.

Fig. 7 is a schematic representation of a detector having a sensor substrate with a low bandgap portion in the form of single layer.

Fig. 8 schematically depicts an expected characteristic shape of an interaction volume for radiation impinging into a sensor substrate.

Fig. 9 depicts a variation on the situation in Fig. 8 for a sensor substrate having a higher mass density.

Fig. 10 depicts a variation on the sensor substrate of Fig. 7 in which the layer is provided at a depth within the sensor substrate.

Fig. 11 depicts a variation on the sensor substrate of Fig. 10 in which a plurality of the layers is provided in a closely spaced group.

Fig. 12 depicts a variation on the sensor substrate of Fig. 10 in which a plurality of widely spaced layers is provided.

Fig. 13 depicts a variation on the sensor substrate of Fig. 11 in which a plurality of the closely spaced groups of layers is provided.

DETAILED DESCRIPTION

Reference will now be made in detail to exemplary embodiments, examples of which are illustrated in the drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses, systems, and methods consistent with aspects related to subject matter that may be recited in the appended claims.

Aspects of the present application relate to systems and methods for charged particle beam detection. Systems and methods may employ counting of charged particles, such as electrons, and may be useful in an inspection tool, such as a scanning electron microscope (SEM). Inspection tools may be used in the manufacturing process of integrated circuit (IC) components. To realize the enhanced computing power of modern day electronic devices, the physical size of the devices may shrink while the packing density of circuit components, such as, transistors, capacitors, diodes, etc., is significantly increased on an IC chip. For example, in a smartphone, an IC chip (which may be the size of a thumbnail) may include over 2 billion transistors, the size of each transistor being less than 1/1,000th of a human hair. Not surprisingly, semiconductor IC manufacturing is a complex process, with hundreds of individual steps. Errors in even one step have the potential to dramatically affect the functioning of the final product. Even one "killer defect" can cause device failure. The goal of the manufacturing process is to improve the overall yield of the process. For example, for a 50-step process to get 75% yield, each individual step must have a yield greater than 99.4%, and if the individual step yield is 95%, the overall process yield drops to 7%.

It is increasingly important to ensure the ability to detect defects with high accuracy and high resolution while maintaining high throughput (defined as the number of wafer processes per hour, for example). High process yields and high wafer throughput may be impacted by the presence of defects, especially when operator intervention is involved. Thus, detection and identification of micro and nano-sized defects by inspection tools (such as a SEM) is important for maintaining high yields and low cost.

In some inspection tools, a sample may be inspected by scanning a beam of high energy electrons over the sample surface. Due to interactions at the sample surface, secondary or backscattered electrons may be generated from the sample that may then be detected by a detector.

Without limiting the scope of the present disclosure, some embodiments may be described in the context of providing detectors and detection methods in systems utilizing electron beams. However, the disclosure is not so limited. Other types of charged particle beams may be similarly applied. Furthermore, systems and methods for detection may be used in other imaging systems, such as optical imaging, photon detection, x-ray detection, ion detection, etc.

As used herein, unless specifically stated otherwise, the term "or" encompasses all possible combinations, except where infeasible. For example, if it is stated that a component includes A or B, then, unless specifically stated otherwise or infeasible, the component may include A, or B, or A and B. As a second example, if it is stated that a component includes A, B, or C, then, unless specifically stated otherwise or infeasible, the component may include A, or B, or C, or A and B, or A and C, or B and C, or A and B and C.

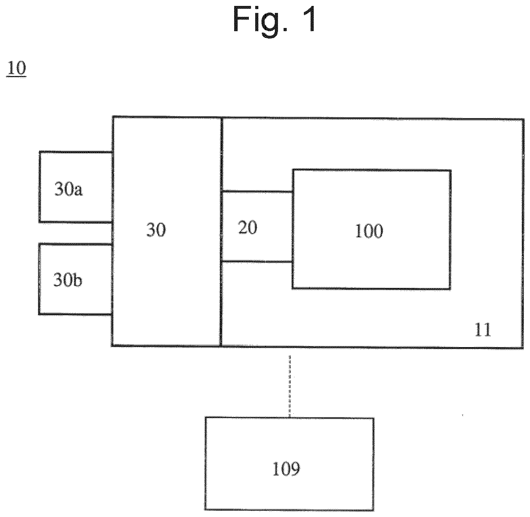

Reference is now made to Fig. 1, which illustrates an exemplary electron beam inspection (EBI) system 10 that may include a detector, consistent with embodiments of the present disclosure. EBI system 10 may be used for imaging. As shown in Fig. 1, EBI system 10 includes a main chamber 11 a load/lock chamber 20, an electron beam tool 100, and an equipment front end module (EFEM) 30. Electron beam tool 100 is located within main chamber 11. EFEM 30 includes a first loading port 30a and a second loading port 30b. EFEM 30 may include additional loading port(s). First loading port 30a and second loading port 30b receive wafer front opening unified pods (FOUPs) that contain wafers (e.g., semiconductor wafers or wafers made of other material(s)) or samples to be inspected (wafers and samples may be collectively referred to as "wafers" herein).

One or more robotic arms (not shown) in EFEM 30 may transport the wafers to load/lock chamber 20. Load/lock chamber 20 is connected to a load/lock vacuum pump system (not shown) which removes gas molecules in load/lock chamber 20 to reach a first pressure below the atmospheric pressure. After reaching the first pressure, one or more robotic arms (not shown) may transport the wafer from load/lock chamber 20 to main chamber 11. Main chamber 11 is connected to a main chamber vacuum pump system (not shown) which removes gas molecules in main chamber 11 to reach a second pressure below the first pressure. After reaching the second pressure, the wafer is subject to inspection by electron beam tool 100. Electron beam tool 100 may be a single-beam system or a multi-beam system. A controller 109 is electronically connected to electron beam tool 100, and may be electronically connected to other components as well. Controller 109 may be a computer configured to execute various controls of EBI system 10. While controller 109 is shown in Fig. 1 as being outside of the structure that includes main chamber 11, load/lock chamber 20, and EFEM 30, it is appreciated that controller 109 can be part of the structure.

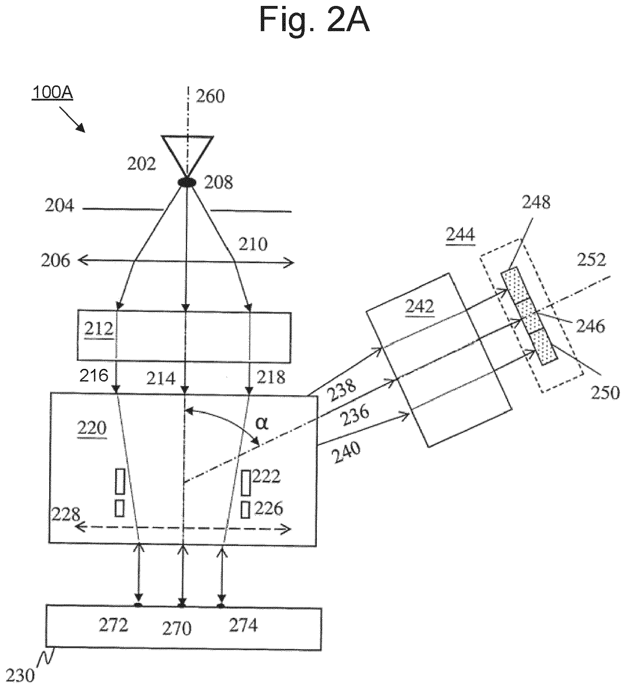

Fig. 2A illustrates a charged particle beam apparatus in which an inspection system may comprise a multi-beam inspection tool that uses multiple primary electron beamlets to simultaneously scan multiple locations on a sample.

As shown in Fig. 2A, an electron beam tool 100A (also referred to herein as apparatus 100A) may comprise an electron source 202, a gun aperture 204, a condenser lens 206, a primary electron beam 210 emitted from electron source 202, a source conversion unit 212, a plurality of beamlets 214, 216, and 218 of primary electron beam 210, a primary projection optical system 220, a wafer stage (not shown in Fig. 2A), multiple secondary electron beams 236, 238, and 240, a secondary optical system 242, and an electron detection device 244. Electron source 202 may generate primary particles, such as electrons of primary electron beam 210. A controller, image processing system, and the like may be coupled to electron detection device 244. Primary projection optical system 220 may comprise a beam separator 222, deflection scanning unit 226, and objective lens 228. Electron detection device 244 may comprise detection sub-regions 246, 248, and 250.

Electron source 202, gun aperture 204, condenser lens 206, source conversion unit 212, beam separator 222, deflection scanning unit 226, and objective lens 228 may be aligned with a primary optical axis 260 of apparatus 100A. Secondary optical system 242 and electron detection device 244 may be aligned with a secondary optical axis 252 of apparatus 100A.

Electron source 202 may comprise a cathode, an extractor or an anode, wherein primary electrons can be emitted from the cathode and extracted or accelerated to form a primary electron beam 210 with a crossover (virtual or real) 208. Primary electron beam 210 can be visualized as being emitted from crossover 208. Gun aperture 204 may block off peripheral electrons of primary electron beam 210 to reduce size of probe spots 270, 272, and 274.

Source conversion unit 212 may comprise an array of image-forming elements (not shown in Fig. 2A) and an array of beam-limit apertures (not shown in Fig. 2A). An example of source conversion unit 212 may be found in U.S. Patent No 9,691,586; U.S. Publication No. 2017/0025243; and International Application No. PCT/EP2017/084429, all of which are incorporated by reference in their entireties. The array of image-forming elements may comprise an array of micro-deflectors or micro-lenses. The array of image-forming elements may form a plurality of parallel images (virtual or real) of crossover 208 with a plurality of beamlets 214, 216, and 218 of primary electron beam 210. The array of beam-limit apertures may limit the plurality of beamlets 214, 216, and 218.

Condenser lens 206 may focus primary electron beam 210. The electric currents of beamlets 214, 216, and 218 downstream of source conversion unit 212 may be varied by adjusting the focusing power of condenser lens 206 or by changing the radial sizes of the corresponding beam-limit apertures within the array of beam-limit apertures. Condenser lens 206 may be a moveable condenser lens that may be configured so that the position of its first principal plane is movable. The movable condenser lens may be configured to be magnetic, which may result in off-axis beamlets 216 and 218 landing on the beamlet-limit apertures with rotation angles. The rotation angles change with the focusing power and the position of the first principal plane of the movable condenser lens. In some embodiments, the moveable condenser lens may be a moveable anti-rotation condenser lens, which involves an anti-rotation lens with a movable first principal plane. Moveable condenser lens is further described in U.S. Publication No. 2017/0025241, which is incorporated by reference in its entirety.

Objective lens 228 may focus beamlets 214, 216, and 218 onto a wafer 230 for inspection and may form a plurality of probe spots 270, 272, and 274 on the surface of wafer 230.

Beam separator 222 may be a beam separator of Wien filter type generating an electrostatic dipole field and a magnetic dipole field. In some embodiments, if they are applied, the force exerted by electrostatic dipole field on an electron of beamlets 214, 216, and 218 may be equal in magnitude and opposite in direction to the force exerted on the electron by magnetic dipole field. Beamlets 214, 216, and 218 can therefore pass straight through beam separator 222 with zero deflection angle. However, the total dispersion of beamlets 214, 216, and 218 generated by beam separator 222 may also be non-zero. Beam separator 222 may separate secondary electron beams 236, 238, and 240 from beamlets 214, 216, and 218 and direct secondary electron beams 236, 238, and 240 towards secondary optical system 242.

Deflection scanning unit 226 may deflect beamlets 214, 216, and 218 to scan probe spots 270, 272, and 274 over a surface area of wafer 230. In response to incidence of beamlets 214, 216, and 218 at probe spots 270, 272, and 274, secondary electron beams 236, 238, and 240 may be emitted from wafer 230. Secondary electron beams 236, 238, and 240 may comprise electrons with a distribution of energies including secondary electrons and backscattered electrons. Secondary optical system 242 may focus secondary electron beams 236, 238, and 240 onto detection sub-regions 246, 248, and 250 of electron detection device 244. Detection sub-regions 246, 248, and 250 may be configured to detect corresponding secondary electron beams 236, 238, and 240 and generate corresponding signals used to reconstruct an image of surface area of wafer 230.

Although Fig. 2A shows an example of electron beam tool 100 as a multi-beam tool that uses a plurality of beamlets, embodiments of the present disclosure are not so limited. For example, electron beam tool 100 may also be a single-beam tool that uses only one primary electron beam to scan one location on a wafer at a time.

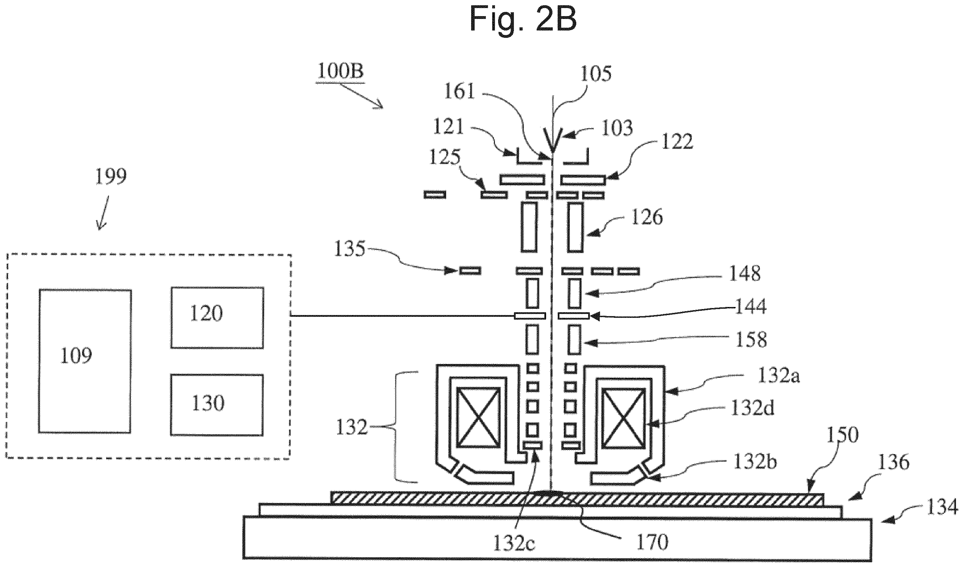

As shown in Fig. 2B, an electron beam tool 100B (also referred to herein as apparatus 100B) may be a single-beam inspection tool that is used in EBI system 10. Apparatus 100B includes a wafer holder 136 supported by motorized stage 134 to hold a wafer 150 to be inspected. Electron beam tool 100B includes an electron emitter, which may comprise a cathode 103, an anode 121, and a gun aperture 122. Electron beam tool 100B further includes a beam limit aperture 125, a condenser lens 126, a column aperture 135, an objective lens assembly 132, and a detector 144. Objective lens assembly 132, in some embodiments, may be a modified SORIL lens, which includes a pole piece 132a, a control electrode 132b, a deflector 132c, and an exciting coil 132d. In an imaging process, an electron beam 161 emanating from the tip of cathode 103 may be accelerated by anode 121 voltage, pass through gun aperture 122, beam limit aperture 125, condenser lens 126, and be focused into a probe spot 170 by the modified SORIL lens and impinge onto the surface of wafer 150. Probe spot 170 may be scanned across the surface of wafer 150 by a deflector, such as deflector 132c or other deflectors in the SORIL lens. Secondary or scattered primary particles, such as secondary electrons or scattered primary electrons emanated from the wafer surface may be collected by detector 144 to determine intensity of the beam and so that an image of an area of interest on wafer 150 may be reconstructed.

There may also be provided an image processing system 199 that includes an image acquirer 120, a storage 130, and controller 109. Image acquirer 120 may comprise one or more processors. For example, image acquirer 120 may comprise a computer, server, mainframe host, terminals, personal computer, any kind of mobile computing devices, and the like, or a combination thereof. Image acquirer 120 may connect with detector 144 of electron beam tool 100B through a medium such as an electrical conductor, optical fiber cable, portable storage media, IR, Bluetooth, internet, wireless network, wireless radio, or a combination thereof. Image acquirer 120 may receive a signal from detector 144 and may construct an image. Image acquirer 120 may thus acquire images of wafer 150. Image acquirer 120 may also perform various post-processing functions, such as generating contours, superimposing indicators on an acquired image, and the like. Image acquirer 120 may be configured to perform adjustments of brightness and contrast, etc. of acquired images. Storage 130 may be a storage medium such as a hard disk, random access memory (RAM), cloud storage, other types of computer readable memory, and the like. Storage 130 may be coupled with image acquirer 120 and may be used for saving scanned raw image data as original images, and post-processed images. Image acquirer 120 and storage 130 may be connected to controller 109. In some embodiments, image acquirer 120, storage 130, and controller 109 may be integrated together as one electronic control unit.

In some embodiments, image acquirer 120 may acquire one or more images of a sample based on an imaging signal received from detector 144. An imaging signal may correspond to a scanning operation for conducting charged particle imaging. An acquired image may be a single image comprising a plurality of imaging areas that may contain various features of wafer 150. The single image may be stored in storage 130. Imaging may be performed on the basis of imaging frames.

The condenser and illumination optics of the electron beam tool may comprise or be supplemented by electromagnetic quadrupole electron lenses. For example, as shown in Fig. 2B, electron beam tool 100B may comprise a first quadrupole lens 148 and a second quadrupole lens 158. In some embodiments, the quadrupole lenses are used for controlling the electron beam. For example, first quadrupole lens 148 can be controlled to adjust the beam current and second quadrupole lens 158 can be controlled to adjust the beam spot size and beam shape.

Fig. 2B illustrates a charged particle beam apparatus in which an inspection system may use a single primary beam that may be configured to generate secondary electrons by interacting with wafer 150. Detector 144 may be placed along optical axis 105, as in the embodiment shown in Fig. 2B. The primary electron beam may be configured to travel along optical axis 105. Accordingly, detector 144 may include a hole at its center so that the primary electron beam may pass through to reach wafer 150. However, some embodiments may use a detector placed off-axis relative to the optical axis along which the primary electron beam travels. For example, as in the embodiment shown in Fig. 2A, beam separator 222 may be provided to direct secondary electron beams toward a detector placed off-axis. Beam separator 222 may be configured to divert secondary electron beams by an angle α.

A detector for detecting radiation may be used to detect electrons in apparatus 100 in EBI system 10. EBI system 10 may be a high-speed wafer imaging SEM including an image processor. An electron beam generated by EBI system 10 may irradiate the surface of a sample or may penetrate the sample. EBI system 10 may be used to image a sample surface or structures under the surface, such as for analyzing layer alignment. In some embodiments, EBI system 10 may detect and report process defects relating to manufacturing semiconductor wafers by, for example, comparing SEM images against device layout patterns, or SEM images of identical patterns at other locations on the wafer under inspection. A detector may include reverse biased junction diode. The reverse biased junction diode may be a PIN diode (e.g., a silicon PIN diode) operating with negative (reverse) bias. The detector may be referred to as a PIN detector in this case.

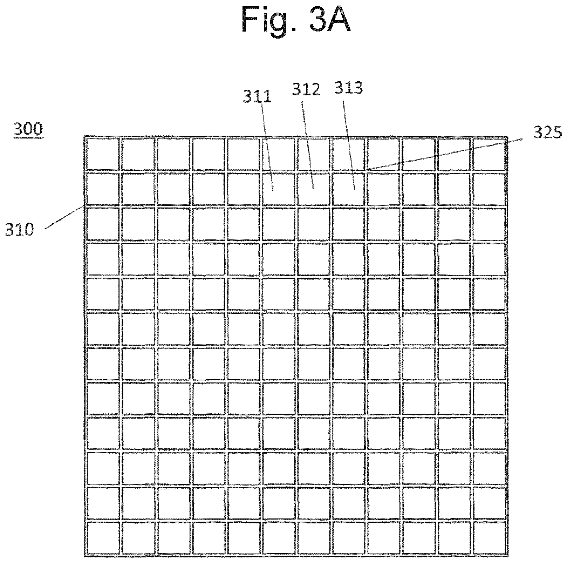

Reference is now made to Fig. 3A, which illustrates a schematic representation of an exemplary structure of a detector 300. Detector 300 may be provided as detector 144 or electron detection device 244 with reference to Fig. 2A and Fig. 2B. While one array is shown in Fig. 3A, it is appreciated that detector 300 may include multiple arrays, such as one array for each secondary electron beam.

Detector 300 may comprise an array of sensing elements, including sensing elements 311, 312, and 313. The sensing elements may be arranged in a planar, two-dimensional array, the plane of the array being substantially perpendicular to an incidence direction of incoming radiation (e.g., charged particles or photons). In some embodiments, detector 300 may be arranged so as to be inclined relative to the incidence direction.

Detector 300 may comprise a substrate 310.

Substrate 310 may be a semiconductor substrate that may include the sensing elements. A sensing element may comprise a diode. A sensing element may also be an element similar to a diode that can convert incident energy into a measurable signal. The sensing elements may comprise, for example, a PIN diode, an avalanche diode, etc., or combinations thereof. An area 325 may be provided between adjacent sensing elements. Area 325 may be an isolation area to isolate the sides or corners of neighboring sensing elements from one another. Area 325 may comprise an insulating material that is a material different from that of other areas of the detection surface of detector 300. Area 325 may be provided as a cross-shaped area as seen in the plane view of Fig. 3A. Area 325 may be provided as a square. In some embodiments, area 325 may not be provided between adjacent sides of sensing elements. For example, in some embodiments, there may be no isolation area provided on a detection surface of a detector.

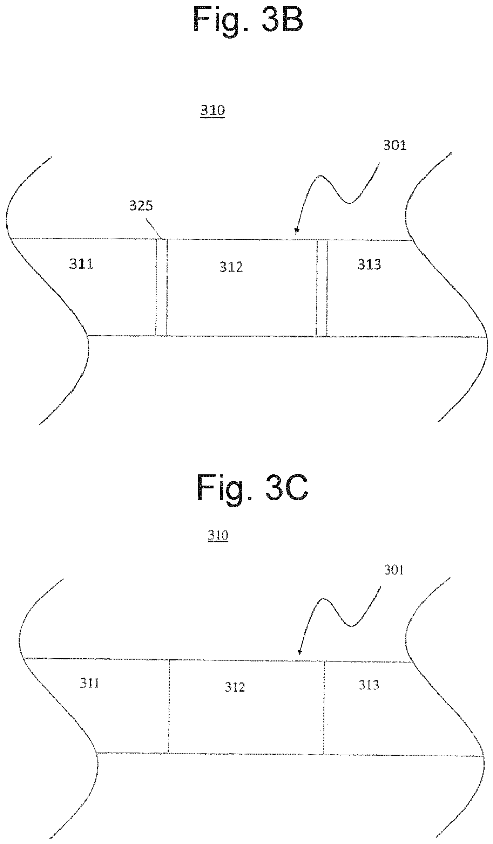

Reference is now made to Fig. 3B, which shows a schematic illustration of a cross-sectional structure of a substrate 310, which may be an example of a structure included in a PIN detector. Substrate 310 may comprise one or more layers. For example, substrate 310 may be configured to have a plurality of layers stacked in a thickness direction, the thickness direction being substantially parallel to an incidence direction of an electron beam. In some embodiments, substrate 310 may have a plurality of layers stacked in a direction perpendicular to the incidence direction of an electron beam. Substrate 310 may be provided with a sensor surface 301 for receiving incident radiation. Sensing elements (for example sensing elements 311, 312, and 313) may be provided in a sensing layer of substrate 310. Area 325 may be provided between adjacent sensing elements. For example, substrate 310 may comprise a trench, or other structure that is made of or filled with insulating material. In some embodiments, area 325 may extend fully or partially through substrate 310. In other words, the insulating material may extend from one surface to a certain depth.

As shown in Fig. 3C, in some embodiments, area 325 is not provided between sensing elements. For example, there may be no insulating material provided between the sides of adjacent sensing elements in cross-sectional view. The plurality of sensing elements may be contiguous in cross-sectional view. Isolation between adjacent sensing elements may still be achieved by other means, such as by controlling electrical field. For example, electrical field may be controlled between each sensing element.

Although the figures may show sensing elements 311, 312, and 313 as discrete units, such divisions may not actually be present. For example, the sensing elements of a detector may be formed by a semiconductor device constituting a PIN diode device. The PIN diode device may be manufactured as a substrate with a plurality of layers including a p-type region, an intrinsic region, and an n-type region. One or more of such layers may be contiguous in cross-sectional view. In some embodiments, however, sensing elements may be provided with physical separation between them. Further layers may also be provided in addition to the sensor layer, such as a circuit layer, and a readout layer, for example.

As one example of a further layer, detector 300 may be provided with one or more circuit layers adjacent to the sensor layer. The one or more circuit layers may comprise line wires, interconnects, and various electronic circuit components. The one or more circuit layers may comprise a processing system. The one or more circuit layers may comprise signal processing circuitries. The one or more circuit layers may be configured to receive the output charge or voltage detected from sensing elements in the sensor layer. The one or more circuit layers and the sensor layer may be provided in the same or separate dies, for example.

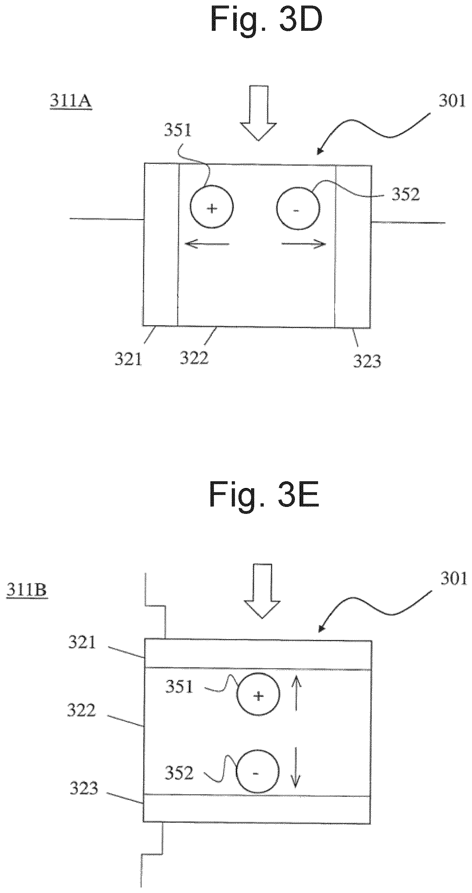

Figs. 3D and 3E show schematic illustrations of example individual sensing elements, each of which may be an example of one of sensing elements 311, 312, and 313. For example, in Fig. 3D, a sensing element 311A is shown. Sensing element 311A may include a semiconductor structure of a p-type layer 321, an intrinsic layer 322, and an n-type layer 323. Sensing element 311A may include two terminals, such as an anode and a cathode. Sensing element 311A may be reverse biased, and a depletion region may form and may span part of the length of p-type layer 321, substantially the entire length of intrinsic layer 322, and part of the length of n-type layer 323. In the depletion region, charge carriers may be removed, and new charge carriers generated in the depletion region may be swept away according to their charge. For example, when an incoming charged particle reaches sensor surface 301, electron-hole pairs may be created, and a hole 351 may be attracted toward p-type layer 321 while an electron 352 may be attracted toward n-type layer 323. In some embodiments, a protection layer may be provided on sensor surface 301.

As shown in Fig. 3E, a sensing element 311B may operate in a similar manner to that of sensing element 311A except that an orientation is changed. For example, p-type layer 321 may include sensor surface 301. P-type layer 321 may be exposed to incident charged particles. Thus, an incident charged particle may interact with p-type layer 321 and the depletion region, and may generate electron-hole pairs. In some embodiments, a metal layer may be provided on top of p-type layer 321.

Background noise in a detector may be caused by, among other things, dark current in a diode. For example, imperfections in a crystal structure of a semiconductor device acting as a diode may cause current fluctuation. Dark current in a detector may be due to defects in materials forming the detector and may arise even when there is no incident irradiation. "Dark" current may refer to the fact that current fluctuation is not related to any incoming charged particle.

In some embodiments of the disclosure, a detector such as a PIN detector may be used as an in-lens detector in a retarding objective lens SEM column of EBI system 10. The detector may be placed between a cathode for generating an electron beam and the objective lens. The electron beam emitted from the cathode may be potentialized at -BE keV (typically around -10 kV). Electrons of the electron beam may be immediately accelerated and travel through the column. The column may be at ground potential. Thus, electrons may travel with kinetic energy of BE keV while passing through an opening in the detector. Electrons passing through the pole piece of the objective lens, such as pole piece 132a of objective lens assembly 132 of Fig. 2B, may be steeply decelerated down to landing energy LE keV as the wafer surface potential may be set at -(BE - LE) keV.

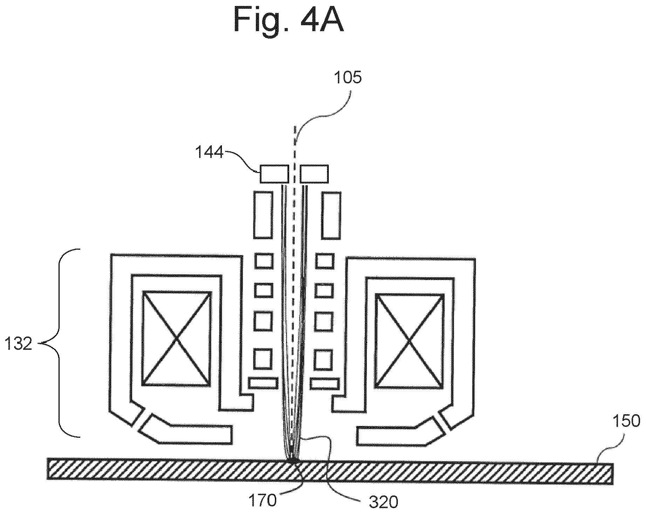

Secondary electrons emitted from the wafer surface by the impingements of electrons of the primary electron beam may be accelerated by an acceleration field (e.g., the retarding electrical field near the wafer may act as an acceleration field for secondary electrons) and travel backwards toward the detector surface. For example, as shown in Fig. 4A, due to interactions with wafer 150 at probe spot 170, secondary electrons may be generated that travel back toward detector 144. Secondary electrons emitted from the wafer surface travelling along optical axis 105 may arrive at the surface of detector 144 with a distribution of positions. The landing positions of secondary electrons may be within a generally circular region with a radius of, for example, a few millimeters. A geometric spread of landing positions of secondary electrons may be due to electrons having different trajectories that may be dependent on, for example, initial kinetic energy and emission angles of the electrons.

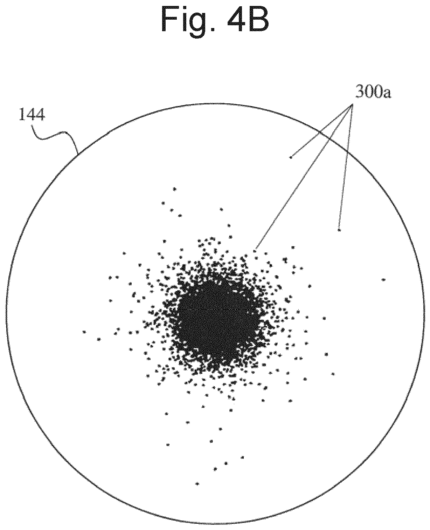

Fig. 4B illustrates an example of secondary electron landing point distribution on a detector surface. Electrons 300a may land at different points on the surface of detector 144 while, generally, most may be clustered around the central portion of detector 144. Landing point distribution may shift depending on secondary emission position and SEM deflection fields (e.g., scan field). Therefore, in some applications, if a certain field of view (FOV) of an SEM image is required, the required size of an in-lens PIN detector may be substantially large. Typically, a detector may be 10 mm in diameter, or larger, for example. In some embodiments, a detector may be about 4 to 10 mm in diameter.

A sensing element may be configured to generate numerous electron-hole pairs in response to an electron arrival event. In some embodiments, electrical charge or voltage generated in response to electron arrival events in a sensing element may be usable as a detection signal. Output of a sensing element in response to an electron arrival event may be used as-is or may undergo amplification. An amplifier may indiscriminately apply amplification to all signals generated in a diode. Therefore, even so-called "dark counts" may be amplified and may contribute to erroneous detection signals.

In an exemplary PIN detector, holes may be excited in a depletion region in an intrinsic region of the PIN detector and may drift by the field created by reverse bias in the PIN detector toward the anode. Then, the holes may be collected at the anode. Electrons generated in the depletion region may drift in an opposite direction to the holes. Thus, electrons may be collected at the cathode, which may be grounded. The holes and electrons created in the depletion region may be recombined with opposite charges within the PIN detector. The recombination rate may be high outside the depletion region. The depletion region may encompass part of the P+ region, which may act as the anode, due to the reverse bias. Recombination of holes or electrons on the side of the P+ region where incident electrons enter the detector may contribute to energy loss and will not contribute to detector signal at the anode terminal. Therefore, it may be desirable to configure the electrode on the side where incident electrons enter the detector to be thin, e.g., to reduce energy loss. For example, in a PIN detector, it may be desirable to configure the P+ layer thickness to be as thin as possible.

Reverse bias applied to a PIN detector may involve voltage application. A diode may be configured to operate with a reverse voltage of a certain amount or less. In some embodiments, the certain amount may be 100 volts. The diode may be operated within a linear region.

In some embodiments, both secondary electrons and backscattered electrons may reach the detector. For example, in a comparative example, approximately 20 to 30% of incoming electrons on a detector may be back-scattered electrons having energy approximately equal to energy of the electrons in the primary beam (e.g., BE). Back-scattered electrons may be the same electrons included in the primary beam generated by an electron source, only having been reflected back off a sample without losing a substantial amount of energy.

Furthermore, some electrons, not having been back-scattered, may lose their kinetic energy by causing a lattice atom in the detector (e.g., in a silicon substrate, a Si atom) to emit its characteristic X-ray photons. Other excitation, such as phonons, etc., may also be generated. Thus, the number of charges created by a single incoming electron having a fixed kinetic energy may vary. That is, electron gain (e.g., the number of charges collected at the terminals of the diode per incoming electron) may vary between incoming electrons.

Charges collected at the terminals of the detector may form a voltage signal. The voltage signal may follow the modulation of incoming electron rate as an electron beam scans over a wafer surface.

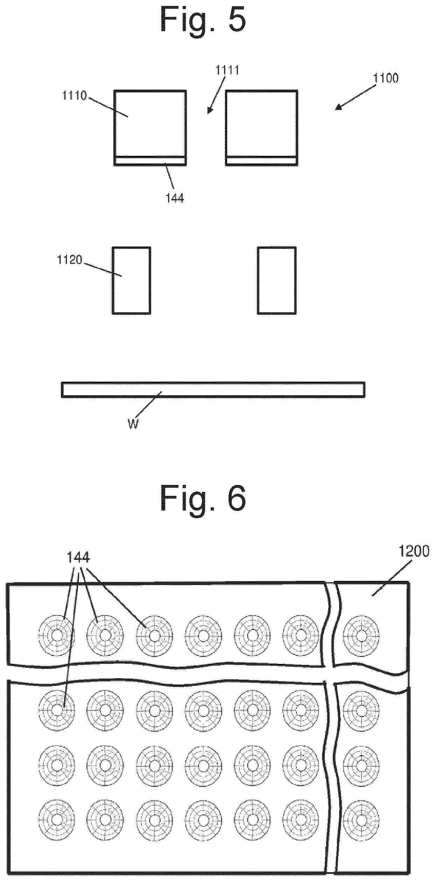

A MEMS-based miniature SEM array is in principle an array of a plurality of miniature SEMs, wherein miniature refers to the size of each element in the array compared to a conventional SEM. For a conventional SEM, the detector may be several millimeters in diameter. However, in MEMS-based miniature SEM, the detector may have a diameter typically smaller than 1 mm, and even smaller than 100 micrometer. Fig. 6 schematically depicts an array 1200 of detectors 144 as can be used in MEMS-based miniature SEM.

Fig. 5 schematically depicts an element 1100 of a MEMS-based miniature array including two annular electrodes 1110 and 1120. A voltage may be applied between the two annular electrodes 1110 and 1120 and between the lower annular electrode 1120 and a substrate W to be examined using the miniature SEM. The electrodes 1110 and 1120 and the voltages applied between them are configured to direct an electron beam coming through a hole 1111 in electrode 1110 towards the substrate W and to direct backscattered or secondary electrons from the substrate W to a detector 144 arranged at a bottom of the electrode 1110.

As mentioned in the introductory part of the description, it may be desirable to increase the strength of a detector output, particularly where a flux of target radiation is relatively low, such as may be the case for low electron beam currents in the context of an inspection system. One approach for achieving this is to increase an active internal gain of the detector based on avalanche but this may bring disadvantages such as the need for time to recover after each avalanche and/or low fill factor. Embodiments of the present disclosure described particularly below aim to increase the strength of the detector output by increasing a passive internal gain of the detector. This is achieved by using low band gap material in a sensor substrate of the detector. Examples and further details about the low band gap material are provided below.

The present disclosure refers mainly to detection of charged particles such as electrons but it will be understood that embodiments can be configured and/or used to detect other types of radiation, including uncharged particles such as photons.

The internal gain, $G_0$, of a solid-state detector may be defined by the following expression:

$$G_0 = \frac{E . I_b (1 - \eta)}{e_i . q}$$

where $E$ is the beam energy in eV, $I_b$ is the beam current in amperes, $\eta$ is the backscattering coefficient, $e_i$ is the bandgap of the sensor substrate of the detector (e.g., 3.65 eV for silicon), and $q$ is the charge of an electron in coulombs. It can be seen from this expression that the internal gain $G_0$ will be increased if the bandgap $e_i$ is reduced. However, decreasing the bandgap may also disadvantageously increase a dark current, which is a source of shot noise. Dark current is current generated in the sensor substrate by mechanisms other than impingement of target radiation. In some scenarios, for example where dark current is not the dominant noise source, benefits from increasing the passive internal gain may outweigh disadvantages from increased dark current. For example, the resulting increased signal strength may reduce demands on electronics (e.g., for amplification), thereby reducing power consumption and/or complexity of the electronics, as well as potentially contributing to reduced signal to noise (SNR) after amplification.

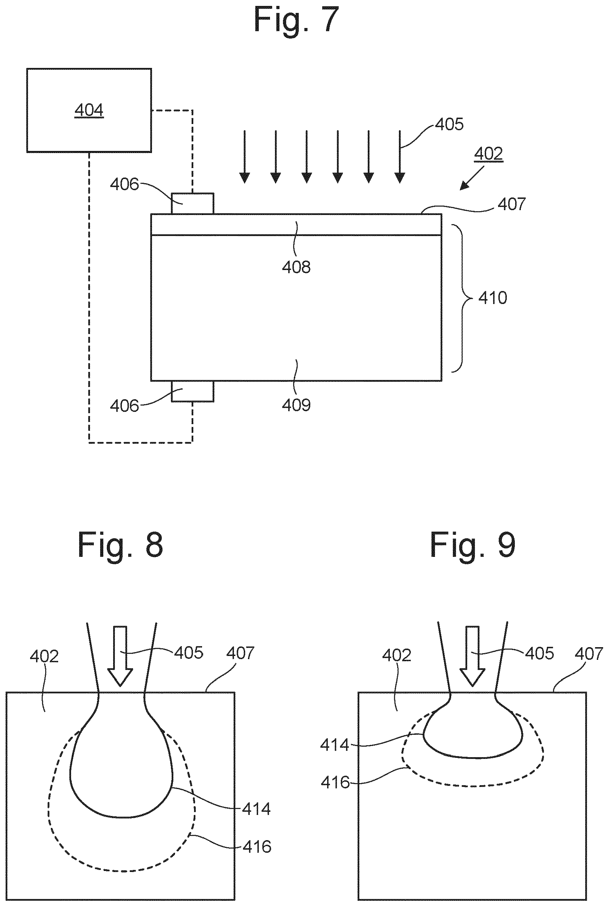

Fig. 7 depicts an example of a detector based at least partly on the above insights. The detector is a detector for detecting radiation. The detector comprises a sensing element. The detector may comprise a single sensing element or an array of the sensing elements. The sensing element may be arranged and/or configured to operate in any of the ways described above with reference to Fig. 3A-3E. The detector may be configured to operate as the detector 144 or the electron detection device 244 described above with reference to Fig. 2A and 2B.

Fig. 7 depicts a single sensing element. The sensing element comprises a semiconducting sensor substrate 402. The sensing element is configured such that impingement of target radiation 405 into the sensor substrate 402 generates charge carriers (e.g., electrons and holes) in the sensor substrate 402. The sensor substrate 402 of the sensing element may be a portion of a larger substrate, such as the substrate 310 discussed above with reference to Fig. 3A-3E. Where an array of the sensing elements is provided, a portion or all of the sensing elements in the array may be formed in a common substrate. The sensor substrates 402 may in this case correspond to different respective portions of the common substrate.

The target radiation 405 may comprise charged particles such as electrons. Alternatively or additionally, the target radiation 405 may comprise photons. The detector comprises readout circuitry 404 configured to provide an output responsive to charge carriers generated in the sensor substrate 402. The readout circuitry 404 may be connected to the sensor substrate 402 via electrical connections 406. The electrical connections may contact the sensor substrate 402 on opposite sides of the sensor substrate 402. The readout circuitry 404 may be configured to apply a potential difference across the sensor substrate 402 via the electrical connections 406. The readout circuitry 404 may be configured to measure a current associated with the charge carriers. The charge carriers may be driven to form a current by the applied potential difference. The readout circuitry 406 may integrate the current over time to measure a total charge associated with charge carriers generated by impingement of the target radiation. The sensor substrate 402 comprises a low bandgap portion consisting of a low bandgap material. The sensor substrate 402 comprises a high bandgap portion consisting of a high bandgap material. The low bandgap material has a bandgap lower than a bandgap of the high bandgap material. The low bandgap material may have a bandgap lower than the bandgap of silicon for example. The high bandgap material may have a bandgap equal to or higher than the bandgap of silicon.

In an embodiment, the readout circuitry 404 is configured to operate the sensing element as a reverse biased diode having a depletion region 410 in the sensor substrate 402. The reverse biased diode may comprise a junction diode, for example an PN junction diode. The junction diode may be doped to define a p-type region adjacent to and/or in electrical contact with an electrical connection 406 on one side of the sensor substrate 402 and an n-type region adjacent to and/or in electrical contact with an electrical connection 406 on the other side of the sensor substrate 402. The junction diode may be a PIN diode, which has a wide, undoped intrinsic semiconductor region between the n-type and p-type regions. The reverse bias is applied by the electrical connections 406 and forms the depletion region 410. The charge carriers generated by the impinging radiation are generated in the depletion region 410 and form a current due to the reverse bias.

The depletion region 410 defines a junction capacitance of the sensing element. The junction capacitance may contribute noise to an input of the readout circuitry 404. The junction capacitance may have a negative impact on bandwidth and power consumption. It is desirable to reduce junction capacitance. The junction capacitance can be reduced by increasing the width of the depletion region 410 (i.e., increasing the vertical height of the depletion region 410 in the orientation shown in Fig. 7). This is analogous to increasing the separation between plates of a parallel plate capacitor. The width of the depletion region 410 may, for example, be set to 100 microns or more. Absorption of target radiation 405 will typically happen, however, over a much smaller depth, typically a few microns for electrons as the target radiation.

In an embodiment, the sensor substrate 402 is made significantly thicker than is necessary for absorption of the target radiation 405. Making the sensor substrate 402 thicker may reduce the junction capacitance. In embodiments of this type, the target radiation may only interact with a small proportion of the sensor substrate 402. A width of the depletion region 410 in a depth direction may be significantly larger than an average penetration depth of the target radiation 405. Any increase of dark current caused by the presence of low bandgap material may be proportional to an amount of the low bandgap material that is present. In some embodiments, dark current is reduced by configuring the sensor substrate 402 to contain both a low bandgap portion (exemplified in Fig. 7 as a low bandgap layer 408 as described below) and a high bandgap portion 409. The high bandgap portion 409 consists of the high bandgap material having a higher bandgap than the low bandgap material. In embodiments where the low bandgap material has a bandgap lower than the bandgap of silicon, the high bandgap material may thus have a bandgap equal to or higher than the bandgap of silicon. The high bandgap material may comprise, consist essentially of, or consist of, silicon.

The high bandgap material may comprise, consist essentially of, or consist of, a material having a higher bandgap than silicon, such as a group 3-5 material (e.g., GaN) or SiC.

In an embodiment, the high bandgap portion 409 forms a majority (e.g., by volume) of the depletion region 410. This may be appropriate for example where the target radiation is absorbed in a volume representing less than half of the depletion region 410. A majority or all of a portion of the sensor substrate 402 that is beyond a penetration depth of the target radiation may for example form all or part of the high bandgap portion 409. Providing higher bandgap material (e.g., silicon) in regions of the sensor substrate 402 that do not interact with the target radiation allows dark current to be reduced without having any negative effect on generation of charge carriers. In an embodiment, as exemplified in Fig. 7, the low bandgap portion may comprise a low bandgap layer 408. The low bandgap layer 408 may be substantially planar and perpendicular to a width of the depletion region 410 in a direction of the reverse bias (i.e., parallel to the vertical dimension of the depletion region 410 in the orientation shown in Fig. 7). The low bandgap layer 408 may be substantially parallel to a surface 407 of the sensing element configured to receive the target radiation 405. In an embodiment, a thickness of the low bandgap layer 408 is less than 25%, optionally less than 10%, optionally less than 5%, of a thickness of the sensor substrate 402 and/or than a width of the depletion region 410 in the direction of the reverse bias.

In an embodiment, as exemplified in Fig. 7, at least a portion of the low bandgap layer 408 is located at, or is nearer than the depletion region 410 to, a surface 407 of the sensing element configured to receive the target radiation. Thus, the low bandgap layer 408 may be at or near the surface 407. Positioning the low bandgap layer 408 at or near the surface 407 may provide good performance for a range of target radiation energy distributions because at least a portion of the target radiation will be absorbed relatively near to the surface 407. In an embodiment, the low bandgap layer 408 provides the surface 407 (i.e., the low bandgap layer is exposed to the environment outside of the sensing element and/or is the first solid element encountered by the target radiation). In an embodiment, the low bandgap layer 408 is provided beneath a passivation layer (not shown) that provides the surface 407, optionally in direct contact with the passivation layer. The depletion region 410 overlaps with the low bandgap layer 408. A portion of the depletion region 410 nearest the surface 407 is within the low bandgap layer 408 and a portion of the depletion region 410 further from the surface 407 is outside of the low bandgap layer 408.

In an embodiment, a thickness of the low bandgap layer 408 is selected as a function of the target radiation. The low bandgap layer 408 may be made thicker for higher energy target radiation and thinner for lower energy target radiation. This approach makes it possible to avoid or minimize low bandgap material being present in regions that are not encountered by the target radiation, thereby helping to keep dark current low.

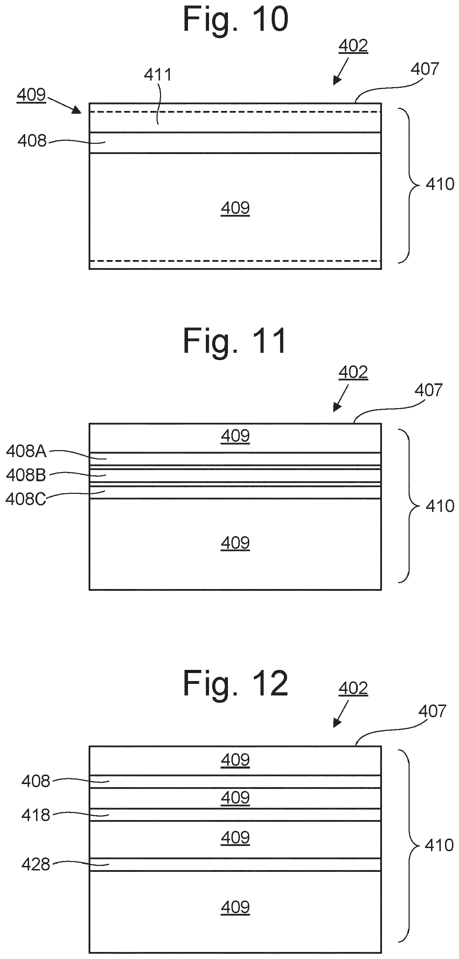

Fig. 8 schematically depicts an expected characteristic shape of an interaction volume 414, 416 between target radiation 405 and the sensor substrate 402. The two different volumes 414 and 416 correspond to different acceleration voltages for incident radiation consisting of charged particles. Different acceleration voltages provide incident charged particles of different respective energies. Interaction volume 416 corresponds to a higher acceleration voltage than volume 414. The interaction volume has a bulbous form in both cases (e.g., with the cross-sectional area being larger than at the surface 407 for a range of depths away from the surface 407). The interaction volume has a maximum cross-sectional area (in a direction parallel with the surface 407) at a finite depth within the sensor substrate 402. In some embodiments, the thickness and/or position (e.g., depth) of the low bandgap layer 408 is/are selected to take account of the shape of the interaction volume. For example, as exemplified in Figure 10, the low bandgap layer 408 may be positioned at a depth within the sensor substrate 402 such that a portion 411 of the depletion region 410 is between the low bandgap layer 408 and the surface 407 of the sensing element configured to receive the target radiation. In the example shown in Fig. 10, the depletion region 410 is the region between horizontal broken lines. The portion 411 may be located within the high bandgap region 409. The depth of the low bandgap layer 408 may be selected to account for the cross-sectional area of the interaction volume being largest at a finite depth. In an embodiment, the low bandgap layer 408 is positioned such that at least a portion of the low bandgap layer 408 is present at a depth where the cross-sectional area of the interaction volume is largest. The thickness and/or position of the low bandgap layer 408 may thus be selected according to an energy distribution or average energy of the target radiation.

The penetration depth of target radiation into the sensor substrate 402 may depend on the mass density of the portion of the sensor substrate 402 encountered by the target radiation. For example, the penetration depth, R, of electrons into a solid of uniform composition may depend on the energy $E_0$ of the electrons and mass density $\rho$ of the solid according to the following expression:

$$R = \frac{0.1 \times E_0^{1.5}}{\rho}$$

The expression estimates a penetration depth of 5 keV electrons in silicon as $R_{Si} \approx 280$ nm. Increasing the mass density of the sensor substrate 402 thus decreases the penetration depth. This is depicted schematically in Fig. 9, which depicts interaction volumes 414, 416 for a case where the sensor substrate 402 has a higher mass density than the sensor substrate 402 of Fig. 8. The decrease in the penetration depth caused by the higher mass density means that charge carriers (e.g., electron-hole pairs) may on average be generated nearer to the surface 407 of the sensing element. This may lead to a loss of gain because electrons generated close to the surface 407 may more easily escape from the surface without contributing to a detected current. Furthermore, there may be higher concentration of defects near to the surface than in the bulk of the sensor substrate 402, which can act as recombination centers. For example, an interface with a passivation layer on the sensor substrate 402 may contribute defects. It is noted that the internal quantum efficiency of the detector may depend on how quickly electrons and holes are separated from each other and moved in opposite directions in the sensor substrate. The separation is facilitated by the electric field in the depletion region 410 provided by the reverse bias. This means that the depletion region 410 has to be close to the surface 407.

The above issues are mitigated by providing the low bandgap layer at a depth within the sensor substrate 402, which encourages electrons to be generated further away from the surface 407. Alternatively or additionally, the above issues may be mitigated by selecting a low bandgap material that has a relatively low mass density, such that the target radiation penetrates more deeply (i.e., such that the interaction volume looks more like Fig. 8 than Fig. 9). In some embodiments, the low bandgap material comprises a material having a lower mass density than silicon. The mass density of silicon is 2.329 $g/cm^3$ so in such embodiments the low bandgap material may comprise, consist essentially of, or consist of, a material having a mass density that is lower than 2.329 $g/cm^3$. In an embodiment, the low bandgap material comprises, consists essentially of, or consists of magnesium silicide, $Mg_2Si$, which has a mass density of 1.99 $g/cm^3$.

The low bandgap material may additionally or alternatively comprise, consist essentially of, or consist of, various other semiconductor materials known to have bandgaps that are smaller than the bandgap of silicon, including any one or more of the following in any combination: mercury cadmium telluride ($Hg_{1-x}Cd_xTe$); mercury zinc telluride ($Hg_{1-x}Zn_xTe$); lead selenide (PbSe); lead telluride (PbTe); indium arsenide (InAs); indium antimonide (InSb); gallium antimonide (GaSb); cadmium arsenide ($Cd_3As_2$); bismuth telluride ($Be_2Te_3$); tin telluride (SnTe); tin selenide (SnSe); silver(I) selenide ($Ag_2Se$); and germanium (Ge).

In an embodiment, the low bandgap layer 408 has a uniform composition. Forming the low bandgap layer 408 with a uniform composition may facilitate manufacture of the low bandgap layer 408. However, any differences between the lattice structure of the material of the low bandgap layer 408 (e.g., symmetry and/or lattice constant or lattice constants) and the lattice structure of material (e.g., silicon) of the sensor substrate 402 that is outside of the low bandgap layer 408 and in contact with the low bandgap layer 408 may contribute defects to the crystal structure of the sensor substrate 402. For example, the low bandgap layer 408 may be grown epitaxially on silicon. During this process the material of the low bandgap layer 408 may seek to adopt the crystal structure of silicon to the extent possible but differences in the crystal structure and/or lattice constant(s) will cause periodic dislocations of atoms to occur at the interface between the low bandgap layer 408 and the silicon. The dislocations can spread through the bulk of the low bandgap layer 408. The dislocations are defects that can act as recombination centers and reduce internal gain.

In some embodiments, this effect is reduced by selecting the low bandgap material to comprise, consist essentially of, or consist of a material having the same crystal structure as the material (e.g., silicon), for example the high bandgap material, of the sensor substrate 402 outside of the low bandgap portion, for example in contact with the low bandgap portion and/or with a lattice constant within 10%, optionally within 7.5 %, optionally within 5%, of a lattice constant of the material of the sensor substrate 402 outside of the low bandgap portion and in contact with the low bandgap portion. Reducing a mismatch between the lattice structure of the low bandgap material and surrounding material may reduce defects such as dislocations. In an embodiment, the low bandgap material comprises, consists essentially of, or consists of, a material having the same crystal structure as silicon and/or with a lattice constant within 10%, optionally within 7.5 %, optionally within 5%, of a lattice constant of silicon. In an embodiment, the low bandgap material comprises germanium and the material of the sensor substrate 402 outside of the low bandgap portion comprises, consists essentially of, or consists of silicon. Silicon and germanium have the same crystal structure and very similar lattice constants (lattice constants are: a = 0.5657 nm for Ge and a = 0.543 nm for Si). Defects caused by growing germanium adjacent to or within silicon are relatively low due to the similarity of the respective lattices.

In an embodiment, the low bandgap layer 408 comprises a mixture of chemical elements having different bandgaps, at least one of the chemical elements having a bandgap smaller than the bandgap of the high bandgap material (e.g., silicon). The mixture may consist of $A_xB_{1-x}$ where A and B represent elements having different bandgaps. The mixture may consist of $Si_xGe_{1-x}$ for example. Mixtures such as $Si_xGe_{1-x}$ can be manufacturing efficiently and in a highly controlled manner using well-known deposition techniques such as epitaxial growth. The epitaxial growth can be done in various ways, including for example using chemical vapor deposition (CVD), physical vapor deposition (PVD), in a high-vacuum environment or in a low-vacuum environment. The processing parameters of the epitaxial growth can be controlled to define the composition of the mixture (e.g., the relative proportions of constituents of the mixture, such as of silicon and germanium) with high precision and flexibility. The composition of the mixture can be made uniform through the whole thickness of the low bandgap layer 408 or can be made to vary as a function of position in the thickness direction. An average bandgap of material in the low bandgap layer 408 can thus be tuned to a desired value, for example to achieve a desirable balance between increased passive internal gain (signal strength) and acceptable levels of dark current. Forming mixtures having constituents with the same or similar crystal structure and/or the same or similar lattice constants may reduce defects and associated recombination centers, thereby enhancing internal gain.

In an embodiment, the low bandgap layer 408 has a non-uniform composition. This may be achieved by the low bandgap layer 408 having a composition that varies as a function of position in a thickness direction of the low bandgap layer 408. In an embodiment, the variation in composition is such that the composition converges towards a composition of material outside of the low bandgap layer 408 and in contact with the low bandgap layer 408 on one or both sides of the low bandgap layer 408. For example, a proportion of the high bandgap material (e.g., silicon) in the composition may gradually decrease as a function of position from one or both sides of the low bandgap layer 408 towards a center of the low bandgap layer 408 in the thickness direction. The proportion of the high bandgap material (e.g., silicon) may thus gradually increase towards one or both sides of the low bandgap layer 408. Arranging for such gradual convergence in composition may reduce mismatches in the lattice at one or both of the interfaces between the low bandgap layer 408 and surrounding material, thereby reducing the amount of lattice defects such as dislocations, thereby reducing recombination events and improving internal gain.

For example, germanium has a direct bandgap that is about 4.5 times smaller than the direct bandgap of silicon, which could in principle lead to 4.5 times higher internal gain. SiGe compounds are widely used already in the semiconductor industry for producing high-frequency devices due to the relatively high mobility of electrons in germanium. It has been established that SiGe compounds can be created as a matter of routine with any composition of Si and Ge: i.e., it is possible to form $Si_xGe_{1-x}$ for any value of x. For such SiGe compounds, the lattice constant varies approximately linearly as a function of the proportion of silicon x between the lattice constant of Si at x = 1 to the lattice constant of Ge at x = 0. Based on the above, in an embodiment the low bandgap layer 408 consists of a $Si_xGe_{1-x}$ layer embedded in silicon. The composition of the low bandgap layer varies, optionally monotonically, optionally linearly, in a thickness direction of the low bandgap layer from $x \geq 0.8$ near each of one or both of the two interfaces to a lower value of x elsewhere in the low bandgap layer, for example in a central region of the low bandgap layer in a thickness direction. The lower value of x may be $x \leq 0.2$, optionally $x \leq 0.1$, or even x = 0.

It has been shown that the bandgap of a thin layer of material can vary as a function of the thickness of the layer. For example, it has been shown that the bandgap of Ge can be reduced to around 0.4 eV for thicknesses of the order of around 50nm and lower. This is two times smaller than the direct bandgap of a thick layer of Ge. Based on this insight, in some embodiments a thickness of the low bandgap layer 408 is selected to be small enough to lower the bandgap of the material of the low bandgap layer 408 in this way. As discussed above, lowering the bandgap can increase passive internal gain. In some configurations, it may be desirable to provide a larger total thickness of low bandgap material to achieve a desired increase in passive internal gain. For example, the desired total thickness of low bandgap material may be such that if the total thickness were embodied in a single layer of the low bandgap material, that single layer would have substantially the same bandgap as is observed for a bulk sample of the material (i.e., not a thin layer). In such a scenario, as exemplified in Fig. 11, a plurality of the low bandgap layers 408A-C may be provided. The low bandgap layers 408A-C are spaced apart from each other. Each of the low bandgap layers 408A-C in the plurality may have a thickness that is small enough to lower the bandgap of the material of the low bandgap layer 408A-C. The low bandgap material of each layer may have a bandgap that is lower, optionally at least 10% lower, optionally at least 25% lower, optionally at least 50% lower, than a bandgap of a bulk sample of the material (or a thicker layer). In the embodiment shown, the plurality of low bandgap layers 408A-C are configured to detect the same target radiation (e.g., particles having the same or similar energies). The plurality of low bandgap layers 408A-C may thus be relatively closely spaced. For example, an average spacing of the low high gain layers is smaller than an average thickness of the low bandgap layers 408A-C.

In an embodiment, as exemplified in Fig. 12, at least a subset of the low bandgap layers 408, 418, 428 are configured to generate charge carriers predominantly from target radiation having different respective energy distributions (e.g., different respective average energies). Thus, each of the layers 408, 418, 428 of the subset may be positioned at significantly different depths within the sensor substrate 402. The depths of the layers 408, 418, 428 correspond to respective expected different penetration depths of the different energy distributions or average energies. For example, in the example of Fig. 12, the layer 408 may be positioned at a relatively shallow depth corresponding to a maximum width of an expected interaction volume of target radiation having a relatively low energy. Layer 418 is positioned at an intermediate depth to target intermediate energy target radiation. Layer 428 is positioned at a deepest depth to target higher energy target radiation. The low bandgap layers 408, 418, 428 in the at least a subset may be spaced apart by more than an average thickness of those low bandgap layers 408, 418, 428. Spacing multiple layers apart in this manner increases flexibility of operation and efficiency by allowing the detector to have a high passive internal gain for a range of different target radiations (e.g., energy distributions and/or average energies) that may have significantly different characteristic interaction volumes within the sensor substrate 402.

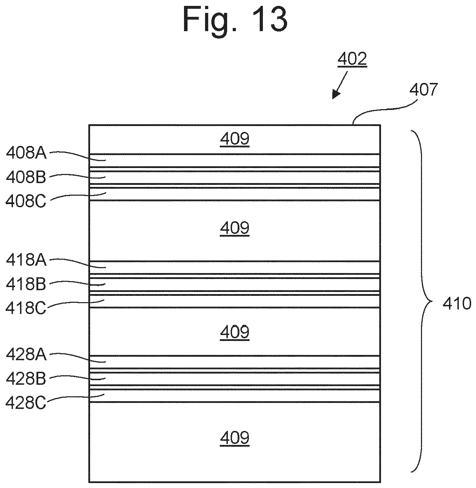

In an embodiment, as exemplified in Fig. 13, the low bandgap layers are provided in plural groups of closely spaced low bandgap layers. Three groups are shown in the example of Fig. 13. A shallowest group comprises the three layers labelled 408A-C. An intermediate group comprises the three layers labelled 418A-C. A deepest group comprises the three layers labelled 428A-C. The groups are configured to generate charge carriers predominantly from target radiation having different respective energy distributions or different respective average energies. The groups of closely spaced low bandgap layers may be spaced apart by more than an average of the sum of the thicknesses of the layers in each group. Thus, a separation between each group may be larger than the average of the sum of the thicknesses of the layers in each group. Providing the low bandgap layers in groups in this manner combines the advantages of the embodiments of Fig. 11 and Fig. 12. Each group is configured to operate particularly well for a different energy distribution or average energy of target radiation while providing multiple layers in each group allows the layers to be made thinner, thereby allowing the bandgaps of the layers to be reduced.

Aspects of the present disclosure discussed above particularly with reference to Fig. 7 to Fig. 13 may be embodied as a method of manufacturing a sensing element. The method may be configured to manufacture the sensing element in any of the forms described above. As described above, the sensing element comprises a semiconducting sensor substrate 402 configured to generate charge carriers on impingement of target radiation into the sensor substrate 402. The sensor substrate 402 comprises a low bandgap layer 408 forming a portion of the sensor substrate 402 and having a bandgap lower than the bandgap of a high bandgap material forming another portion of the sensor substrate (e.g., silicon). In an embodiment, the method of manufacturing the sensing element comprises obtaining information about an energy distribution of the target radiation. The information about the energy distribution may comprise an expected average energy of the target radiation. The method comprises using the obtained information to select a thickness and/or position of the low bandgap layer 408 in the sensor substrate 402. The method comprises forming the sensor substrate 402 with the low bandgap layer 408 according to the selected thickness and/or position. For example, the sensor substrate 402 may be formed by an epitaxial growth process. Processing parameters of the epitaxial growth process may be controlled during the growth process to define the composition profile of the sensor substrate 402 along a thickness direction of the sensor substrate 402. The composition profile may be controlled to form the low bandgap layer 408 to have the selected position and/or thickness. Alternatively or additionally, the method may comprise forming a plurality of candidate sensor substrates with different configurations of the low bandgap layer. The different configurations may include either or both of different thicknesses and different positions of the low bandgap layer in the sensor substrate. In such embodiments, the method may comprise measuring internal gains of the candidate sensor substrates when subjected to target radiation and selecting as a final configuration of the low bandgap layer the configuration corresponding to the highest measured internal gain. The method may then comprise manufacturing the sensor element by forming the sensor substrate with the low bandgap layer according to the selected final configuration of the low bandgap layer. Any of the methods described above may be extended to form any of the arrangements described above with reference particularly to Fig. 7-13, including forming multiple low bandgap layers 408, closely spaced and/or widely spaced low bandgap layers, one or more low bandgap layers of uniform composition, and/or one or more low bandgap layers of non-uniform composition.

Embodiments of the disclosure are further defined in the following numbered clauses.

Clause 1: A detector for detecting radiation, comprising:

a sensing element comprising a semiconducting sensor substrate, the sensing element being configured such that impingement of target radiation into the sensor substrate generates charge carriers in the sensor substrate; and readout circuitry configured to provide an output responsive to charge carriers generated in the sensor substrate, wherein: the sensor substrate comprises a low bandgap portion consisting of a low bandgap material and a high bandgap portion consisting of a high bandgap material, the low bandgap material having a bandgap lower than a bandgap of the high bandgap material.

Clause 2: The detector of clause 1, wherein the low bandgap material has a bandgap lower than the bandgap of silicon.

Clause 3: The detector of clause 1 or 2, wherein the high bandgap material has a bandgap equal to or higher than the bandgap of silicon.

Clause 4: The detector of any preceding clause, wherein the readout circuitry is configured to operate the sensing element as a reverse biased diode having a depletion region in the sensor substrate, the charge carriers being generated in the depletion region in the sensor substrate.

Clause 5: The detector of clause 4, wherein the high bandgap portion forms a majority of the depletion region.

Clause 6: The detector of clause 4 or 5, wherein the low bandgap portion comprises a low bandgap layer.

Clause 7: The detector of clause 6, wherein the low bandgap layer is substantially planar and perpendicular to a width of the depletion region in a direction of the reverse bias and/or to a surface of the sensing element configured to receive the target radiation.

Clause 8: The detector of clause 7, wherein a thickness of the low bandgap layer is less than 25% of a thickness of the sensor substrate.

Clause 9: The detector of clause 7 or 8, wherein at least a portion of the low bandgap layer is located at, or is nearer than the depletion region to, a surface of the sensing element configured to receive the target radiation.

Clause 10: The detector of clause 7 or 8, wherein the low bandgap layer is provided at a depth within the sensor substrate such that a portion of the depletion region is between the low bandgap layer and a surface of the sensing element configured to receive the target radiation.

Clause 11: The detector of clause 10, wherein the thickness and/or position of the low bandgap layer is/are selected according to an energy distribution of the target radiation, optionally an average energy of the target radiation.

Clause 12: The detector of any of clauses 6 to 11, wherein the low bandgap layer has a uniform composition.

Clause 13: The detector of any of clauses 6 to 11, wherein the low bandgap layer has a non-uniform composition.

Clause 14: The detector of clause 13, wherein the low bandgap layer has a composition that varies as a function of position in a thickness direction of the low bandgap layer.

Clause 15: The detector of clause 14, wherein the variation in composition is such that the composition converges towards a composition of material outside of the low bandgap layer and in contact with the low bandgap layer on one or both sides of the low bandgap layer.

Clause 16: The detector of clause 15, wherein a proportion of the high bandgap material in the composition gradually decreases as a function of position from one or both sides of the low bandgap layer towards a center of the low bandgap layer in the thickness direction.

Clause 17: The detector of any of clauses 6 to 16, wherein the low bandgap layer comprises a mixture of chemical elements having different bandgaps, at least one of the chemical elements having a bandgap smaller than the bandgap of the high bandgap material, the mixture optionally consisting of $A_xB_{1-x}$ where A and B represent elements having different bandgaps.

Clause 18: The detector of clause 17, wherein the high bandgap material comprises silicon and the mixture consists of $Si_xGe_{1-x}$.

Clause 19: The detector of any of clauses 6 to 18, wherein the low bandgap portion comprises a plurality of the low bandgap layers.

Clause 20: The detector of clause 19, wherein the plurality of low bandgap layers are spaced apart from each other.

Clause 21: The detector of clause 19 or 20, wherein each of the low bandgap layers has a thickness that is small enough to lower the bandgap of the material of the low bandgap layer.

Clause 22: The detector of clause 21, wherein an average spacing of the low bandgap layers of the plurality is smaller than an average thickness of the low bandgap layers.

Clause 23: The detector of any of clauses 19 to 22, wherein:

at least a subset of the low bandgap layers are configured to generate charge carriers predominantly from target radiation having different respective energy distributions or different respective average energies; or

the low bandgap layers are provided in plural groups of closely spaced low bandgap layers, the groups being configured to generate charge carriers predominantly from target radiation having different respective energy distributions or different respective average energies.

Clause 24: The detector of clause 23, wherein:

low bandgap layers in the at least a subset are spaced apart by more than an average thickness of those low bandgap layers; or

the groups of closely spaced low bandgap layers are spaced apart by more than an average of the sum of the thicknesses of the layers in each group.

Clause 25: The detector of any preceding clause, wherein the high bandgap material comprises silicon.

Clause 26: The detector of any of preceding clause, wherein the low bandgap material comprises a material having a lower mass density than the high bandgap material.

Clause 27: The detector of clause 26, wherein the low bandgap material comprises $Mg_2Si$.

Clause 28: The detector of any preceding clause, wherein the low bandgap material comprises a material having the same crystal structure as the high bandgap material and/or with a lattice constant within 10% of a lattice constant of the high bandgap material.

Clause 29: The detector of clause 28, wherein the high bandgap material comprises silicon and the low bandgap material comprises germanium.

Clause 30: A method of manufacturing a sensing element for a detector for detecting radiation, wherein:

the sensing element comprises a semiconducting sensor substrate configured to generate charge carriers on impingement of target radiation into the sensor substrate, the sensor substrate comprises a low bandgap layer forming a portion of the sensor substrate and having a bandgap lower than the bandgap of a high bandgap material forming another portion of the sensor substrate, and the method comprises:

forming a plurality of candidate sensor substrates with different configurations of the low bandgap layer, the different configurations including either or both of different thicknesses and different positions of the low bandgap layer in the sensor substrate;

measuring internal gains of the candidate sensor substrates when subjected to target radiation;

selecting as a final configuration of the low bandgap layer the configuration corresponding to the highest measured internal gain; and

manufacturing the sensor element by forming the sensor substrate with the low bandgap layer according to the selected final configuration of the low bandgap layer.

It will be appreciated that the present invention is not limited to the exact construction that has been described above and illustrated in the accompanying drawings, and that various modifications and changes can be made without departing from the scope thereof.

It will be understood that elements shown in separate figures may be combined.

Furthermore, while scanning electron microscopy has been discussed with reference to some embodiments, other types of systems may be applicable as well. For example, a detector may be used in transmission electron microscopy (TEM), scanning transmission electron microscopy (STEM), or structured illumination microscopy (SIM) systems.

## Claims

1. A detector for detecting radiation, comprising:

a sensing element comprising a semiconducting sensor substrate, the sensing element being configured such that impingement of target radiation into the sensor substrate generates charge carriers in the sensor substrate; and

readout circuitry configured to provide an output responsive to charge carriers generated in the sensor substrate, wherein:

the sensor substrate comprises a low bandgap portion consisting of a low bandgap material and a high bandgap portion consisting of a high bandgap material, the low bandgap material having a bandgap lower than a bandgap of the high bandgap material.

2. The detector of claim 1, wherein the low bandgap material has a bandgap lower than the bandgap of silicon, and wherein the high bandgap material has a bandgap equal to or higher than the bandgap of silicon.

3. The detector of any preceding claim, wherein the readout circuitry is configured to operate the sensing element as a reverse biased diode having a depletion region in the sensor substrate, the charge carriers being generated in the depletion region in the sensor substrate.

4. The detector of claim 3, wherein the high bandgap portion forms a majority of the depletion region.

5. The detector of claim 3 or 4, wherein the low bandgap portion comprises a low bandgap layer.

6. The detector of claim 5, wherein the low bandgap layer is substantially planar and perpendicular to a width of the depletion region in a direction of the reverse bias and/or to a surface of the sensing element configured to receive the target radiation.

7. The detector of claim 6, wherein the low bandgap layer is provided at a depth within the sensor substrate such that a portion of the depletion region is between the low bandgap layer and a surface of the sensing element configured to receive the target radiation.

8. The detector of claim 7, wherein the thickness and/or position of the low bandgap layer is/are selected according to an energy distribution of the target radiation, optionally an average energy of the target radiation.

9. The detector of any of claims 5 to 8, wherein the low bandgap layer has a non-uniform composition that varies as a function of position in a thickness direction of the low bandgap layer.

10. The detector of claim 9, wherein the variation in composition is such that the composition converges towards a composition of material outside of the low bandgap layer and in contact with the low bandgap layer on one or both sides of the low bandgap layer.

11. The detector of claim 10, wherein a proportion of the high bandgap material in the composition gradually decreases as a function of position from one or both sides of the low bandgap layer towards a center of the low bandgap layer in the thickness direction.

12. The detector of any of claims 5 to 11, wherein the low bandgap layer comprises a mixture of chemical elements having different bandgaps, at least one of the chemical elements having a bandgap smaller than the bandgap of the high bandgap material, the mixture optionally consisting of $A_xB_{1-x}$ where A and B represent elements having different bandgaps.

13. The detector of claim 12, wherein the high bandgap material comprises silicon and the mixture consists of $Si_xGe_{10-x}$.

14. The detector of any of claims 5 to 13, wherein the low bandgap portion comprises a plurality of the low bandgap layers, and wherein the plurality of low bandgap layers are spaced apart from each other.

15. The detector of claim 14, wherein:

at least a subset of the low bandgap layers are configured to generate charge carriers predominantly from target radiation having different respective energy distributions or different respective average energies; or
the low bandgap layers are provided in plural groups of closely spaced low bandgap layers, the groups being configured to generate charge carriers predominantly from target radiation having different respective energy distributions or different respective average energies.

# Fig. 1

10

# Fig. 2A

# Fig. 2B

# Fig. 3A

311 312 313

300

325

310

# Fig. 3B

310

301

325

| 311 | 312 | 313 |

# Fig. 3C

310

301

| 311 | 312 | 313 |

# Fig. 3D

# Fig. 3E

# Fig. 4A

EP 4 390 464 A1

Fig. 4B

# Fig. 5

# Fig. 6

# Fig. 7

# Fig. 8

# Fig. 9

# Fig. 10

# Fig. 11

# Fig. 12

# Fig. 13

402

407

409

408A
408B
408C

409

418A
418B
418C

409

428A
428B
428C

409

410

Europäisches
Patentamt

European
Patent Office

Office européen
des brevets

# EUROPEAN SEARCH REPORT

Application Number

EP 22 21 6582

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/240842 A1 (MEYLAN CLAUDE [CH] ET AL) 23 August 2018 (2018-08-23) * paragraphs [0075] – [0076] * * paragraphs [0086] – [0089] * * figures 3A, 4D * | 1-6,9-15 | INV. G01T1/24 H01L31/115 H01L31/028 |
| X | US 2007/034898 A1 (TENNANT WILLIAM E [US] ET AL) 15 February 2007 (2007-02-15) * paragraphs [0020], [0023] – [0031] * * figures 1-4 * | 1-6 | |
| A | | 10 | |
| X | EP 2 088 451 A1 (PANALYTICAL BV [NL]) 12 August 2009 (2009-08-12) * paragraphs [0020] – [0034] * * paragraphs [0053] – [0058] * * figures 1, 3 * | 1,2 | |
| A | | 3-14 | |
| A | WO 2022/135971 A1 (ASML NETHERLANDS BV [NL]) 30 June 2022 (2022-06-30) * paragraphs [0059] – [0063] * * paragraphs [0070] – [0072] * * paragraphs [0081] – [0083] * * figures 5A, 5B, 6 * | 1-15 | |

TECHNICAL FIELDS SEARCHED (IPC)

G01T
H01L
H01J

The present search report has been drawn up for all claims

1

| Place of search | Date of completion of the search | Examiner |
|---|---|---|
| Berlin | 6 June 2023 | Weis, Thomas |

EPO FORM 1503 03.82 (P04C01)

## ANNEX TO THE EUROPEAN SEARCH REPORT
## ON EUROPEAN PATENT APPLICATION NO.

EP 22 21 6582

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2023

| Patent document cited in search report | | Publication date | Patent family member(s) | | Publication date |
|---|---|---|---|---|---|
| US 2018240842 | A1 | 23-08-2018 | CN | 108140658 A | 08-06-2018 |
| | | | EP | 3345220 A1 | 11-07-2018 |
| | | | JP | 6903662 B2 | 14-07-2021 |
| | | | JP | 2018534087 A | 22-11-2018 |
| | | | KR | 20180074671 A | 03-07-2018 |
| | | | US | 2018240842 A1 | 23-08-2018 |
| | | | WO | 2017037527 A1 | 09-03-2017 |
| US 2007034898 | A1 | 15-02-2007 | TW | 200727505 A | 16-07-2007 |
| | | | US | 2007034898 A1 | 15-02-2007 |
| | | | WO | 2007089222 A2 | 09-08-2007 |
| EP 2088451 | A1 | 12-08-2009 | CN | 101521246 A | 02-09-2009 |
| | | | EP | 2088451 A1 | 12-08-2009 |
| | | | JP | 5254066 B2 | 07-08-2013 |
| | | | JP | 2009186475 A | 20-08-2009 |
| | | | US | 2009200478 A1 | 13-08-2009 |
| WO 2022135971 | A1 | 30-06-2022 | TW | 202232550 A | 16-08-2022 |
| | | | WO | 2022135971 A1 | 30-06-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9691586 B
- US 20170025243 A
- EP 2017084429 W
- US 20170025241 A